(19) Europäisches Patentamt
European Patent Office
Office européen des brevets

(11) **EP 4 779 875 A1**

(12) **EUROPEAN PATENT APPLICATION**

(43) Date of publication:
**22.07.2026 Bulletin 2026/30**

(21) Application number: **26151469.9**

(22) Date of filing: **13.01.2026**

(51) International Patent Classification (IPC):
**H03K 23/66** $^{(2006.01)}$

(52) Cooperative Patent Classification (CPC):
**H03K 23/667**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **17.01.2025 US 202563746378 P**
**05.01.2026 US 202619440257**

(71) Applicant: **STMicroelectronics International N.V.**
**1228 Plan-les-Ouates, Geneva (CH)**

(72) Inventor: **TIWARI, Jeet Narayan**
**201308 Greater Noida (IN)**

(74) Representative: **Casalonga**
**Casalonga & Partners**
**Bayerstraße 71/73**
**80335 München (DE)**

(54) **PROGRAMMABLE HIGH-SPEED FREQUENCY DIVIDER**

(57) A high-speed frequency divider (100), a method for generating an output signal (110) proportional to an input signal (106) by a frequency division factor (102), and a phase-locked loop comprising a high-speed frequency divider (100) are provided. The high-speed frequency divider (100) comprises a reduced frequency clock, an asynchronous clock divider, and clock selection circuitry. The reduced frequency clock is generated by dividing an input signal (106) by a clock reduction factor (104). The asynchronous clock divider updates an initial programmed count in synchronization with the reduced frequency clock to generate a frequency divided signal. The initial programmed count is based on the frequency division factor and the clock reduction factor (104). Clock selection circuitry selects a phase of the reduced frequency clock based on a received selection signal. The output signal (110) is based on the frequency divided signal and the selected phase of the plurality of phases.

FREQUENCY DIVISION FACTOR
102

CLOCK REDUCTION FACTOR
104

INPUT SIGNAL
106

HIGH SPEED FREQUENCY DIVIDER
100

OUTPUT SIGNAL
110

FIG. 1

## Description

## TECHNOLOGICAL FIELD

Embodiments of the present disclosure relate generally to high speed frequency dividers, and more particularly, to dynamically programmable high-speed frequency dividers.

## BACKGROUND

A frequency divider plays a crucial role in setting and maintaining the output frequency of a phase-locked loop (PLL) relative to a reference frequency. When in the feedback loop of a phase-locked loop, a frequency divider may divide the output signal by a specified integer or fractional value. The divided frequency is then fed back into a phase detector within the phase-locked loop where it is compared to a reference frequency. By adjusting the division ratio of the frequency divider, the phase-locked loop can generate an output frequency that is a multiple of the reference frequency.

Applicant has identified many technical challenges and difficulties associated with performing a frequency divide operation at a frequency divider, particular at high frequencies. Through applied effort, ingenuity, and innovation, Applicant has solved problems related to performing a frequency divide operation at high frequencies by developing solutions embodied in the present disclosure, which are described in detail below.

## SUMMARY

Various embodiments are directed to an example high-speed frequency divider, a method for generating an output signal proportional to an input signal by a frequency division factor, and a phase-locked loop comprising a high-speed frequency divider.

In an embodiment, the disclosure provides an high-speed frequency divider, configured to generate an output signal proportional to an input signal by a frequency division factor. The input signal oscillates at a reference frequency. The high-speed frequency divider comprises a reduced frequency clock, an asynchronous clock divider, and clock selection circuitry. The reduced frequency clock oscillates at a reduced frequency, wherein the reduced frequency clock is generated by dividing the input signal clock reduction factor. The asynchronous clock divider is configured to update an initial programmed count in synchronization with the reduced frequency clock and generate a frequency divided signal based on the initial programmed count, wherein the initial programmed count is based on the frequency division factor and the clock reduction factor. The clock selection circuitry is configured to generate a plurality of phases of the reduced frequency clock and select a selected phase of the plurality of phases based on a received selection signal. The output signal is based on the frequency divided signal generated by the asynchronous clock divider and the selected phase of the plurality of phases.

In embodiments, the high-speed frequency divider may further comprise one or more of the following features, or combination thereof :

In some embodiments, the clock selection circuitry is configured to generate a clock selection output signal, and the output signal is generated by dividing the clock selection output signal by an output divide factor.

In some embodiments, the initial programmed count at the asynchronous clock divider is determined by performing an integer division operation on the frequency division factor by a product of the output divide factor and the clock reduction factor.

In some embodiments, the integer division operation generates an integer division remainder based on a remainder of the integer division operation on the frequency division factor by the product of the output divide factor and the clock reduction factor.

In some embodiments, the integer division remainder is accumulated as an accumulated integer division remainder between successive divide operations, wherein the initial programmed count is incremented in an instance in which the accumulated integer division remainder is equal to one.

In some embodiments, the clock selection circuitry includes a clock selection mux configured to select a selected clock signal to output as the clock selection output signal based on the selection signal.

In some embodiments, a next selected signal indicating a next selected phase of the plurality of phases at the clock selection circuitry is generated based on one or more least significant bits of the frequency division factor, the selection signal, the output signal, and each of the plurality of phases of the reduced frequency clock.

In some embodiments, the next selected signal is incremented by the one or more least significant bits of the frequency division factor in an instance in which the output signal and each phase of the plurality of phases of the clock selection circuitry is asserted.

In some embodiments, the output divide factor is two.

In some embodiments, a number of phases comprising the plurality of phases received at the clock selection circuitry is based on the clock reduction factor.

In an embodiment of the disclosure, a method for generating an output signal proportional to an input signal by a frequency division factor is further provided. The method comprises: receiving the input signal oscillating at a reference frequency; dividing the input signal by a clock reduction factor to generate a reduced frequency clock; generating an initial programmed count based on the frequency division factor and the clock reduction factor; generating a frequency divided signal based on the initial programmed count at an asynchronous clock divider receiving the reduced frequency clock; generating a plurality of phases of the reduced frequency clock; determining, at clock selection circuitry, a selected phase of the plurality of phases based on a selection signal; and generating the output signal based on the frequency divided signal generated by the asynchronous clock divider and the selected phase of the plurality of phases.

In embodiments, the high-speed frequency divider may further comprise one or more of the following steps, or combination thereof :

In some embodiments, the method further comprises generating, at the clock selection circuitry, a clock selection output signal; and dividing the clock selection output signal by an output divide factor to generate the output signal.

In some embodiments, the method further comprises executing an integer division operation on the frequency division factor and a product of the output divide factor and the clock reduction factor; and determining the initial programmed count based on the integer division operation.

In some embodiments, the method further comprises determining an integer division remainder based on a remainder of the integer division operation.

In some embodiments, the method further comprises accumulating the integer division remainder between successive divide operations; and incrementing the initial programmed count in an instance in which the accumulated integer division remainder is equal to one.

In some embodiments, the method further comprises outputting, from a clock selection mux of the clock selection circuitry, a selected clock signal, as the clock selection output signal based on the selection signal.

In some embodiments, the method further comprises determining a next selected signal indicating a next selected phase of the plurality of phases at the clock selection circuitry based on one or more least significant bits of the frequency division factor, the selection signal, the output signal, and each of the plurality of phases of the reduced frequency clock.

In some embodiments, the method further comprises incrementing the next selected signal by the one or more least significant bits of the frequency division factor in an instance in which the output signal and each phase of the plurality of phases of the clock selection circuitry is asserted.

In some embodiments, the method further comprises determining a number of phases comprising the plurality of phases received at the clock selection circuitry based on the clock reduction factor.

In an embodiment of the disclosure, a phase-locked loop configured to generate a phase-locked signal based on a reference signal is further provided. The phase-locked loop comprises a voltage-controlled oscillator, a low-pass filter, a charge pump circuit, a phase frequency detector, and the above described high-speed frequency divider, wherein the output signal is the feedback signal and the input signal is the phase-locked signal.

## BRIEF DESCRIPTION OF THE DRAWINGS

Reference will now be made to the accompanying drawings. The components illustrated in the figures may or may not be present in certain embodiments described herein. Some embodiments may include fewer (or more) components than those shown in the figures in accordance with an example embodiment of the present disclosure.

FIG. 1 illustrates an example high-level block diagram of a high-speed frequency divider in accordance with an example embodiment of the present disclosure.

FIG. 2 illustrates an example block diagram of a high-speed frequency divider in accordance with an example embodiment of the present disclosure.

FIG. 3 illustrates an example circuit diagram of a high-speed frequency divider in accordance with an example embodiment of the present disclosure.

FIG. 4 illustrates an example circuit diagram of selection signal circuitry in accordance with an example embodiment of the present disclosure.

FIG. 5 illustrates an example signal diagram of an example divide by nine operation in accordance with an example embodiment of the present disclosure.

FIG. 6 depicts an example signal diagram of various divide operations in accordance with an example embodiment of the present disclosure.

FIG. 7 illustrates a flow diagram depicting a process for generating an output signal proportional to an input signal by a frequency division factor in accordance with an example embodiment of the present disclosure.

FIG. 8 depicts a block diagram of an example phase-locked loop in accordance with an example embodiment of the present disclosure.

## DETAILED DESCRIPTION

Example embodiments will be described more fully hereinafter with reference to the accompanying drawings, in which some, but not all embodiments of the inventions of the disclosure are shown. Indeed, embodiments of the disclosure may be embodied in many different forms and should not be construed as limited to the embodiments set forth herein; rather, these embodiments are provided so that this disclosure will satisfy applicable legal requirements. Like numbers refer to like elements throughout.

Various example embodiments address technical problems associated with performing frequency division operations, particularly in association with a high-speed clock. As understood by those of skill in the field to which the present disclosure pertains, there are numerous example systems which may benefit from frequency division operations accurately performed at high clock speeds.

For example, a phase-locked loop is an electronic circuit that synchronizes an output signal's phase and frequency to a reference signal. In general, a phase-locked loop determines an error between the reference signal and a feedback signal of the phase-locked loop and utilizes the difference to adjust the voltage supplied to a voltage-controlled oscillator. The relationship of the frequency of the output signal may be adjusted relative to the input signal based on a frequency divider in the feedback path of the phase-locked loop. Phase-locked loops may be utilized in many applications, for example, applications involving frequency synthesis, such as radio transmitters, receivers, and signal generators; clock generation, such as clock generation blocks in CPUs, GPUs, and networking equipment; communication systems, such as synchronizing data signals in wired and wireless communications; motor control and robotics applications; telecommunications applications; and so on.

In some embodiments, a frequency divider may utilize an asynchronous clock divider to generate an output signal with reduced frequency relative to an input signal. For example, an asynchronous clock divider may use a chain of flip-flops connected in series with each flip-flop toggling on the edge of the clock signal from the previous stage. Such an arrangement divides the clock frequency by powers of two at each stage. In some embodiments, when a non-power of two division factor is desired, the asynchronous clock divider may be loaded with a particular value. The asynchronous clock divider may then reduce the count until zero is reached. Once zero is reached, the output signal is flipped. For example, to divide an input signal by five, the asynchronous clock divider may be loaded with an initial programmed count of five (or three in an n-plus-two asynchronous clock divider). The asynchronous clock divider reduces the programmed count with each cycle of the input signal. Once the count reaches zero, the output signal is flipped. Thus, the output signal is divided by a factor of five compared to the input signal.

Programming an asynchronous clock divider according to an initial programmed count may work at low frequencies (e.g., less than 2 gigahertz), however, an asynchronous clock divider may experience problems and/or limitations as the frequency of the input signal increases. For example, an asynchronous clock divider may require certain loading, setup, and/or hold times associated with the programmed count to ensure proper operation. The loading of an initial programmed count at the asynchronous clock divider may become a critical path of the frequency divider at high frequencies. In such an instance, if the load, setup, and/or hold times are violated, the frequency divider may experience inaccuracies.

The various example embodiments described herein utilize various techniques to reduce the clock frequency at the asynchronous clock divider, enabling the frequency divider to divide high frequency input signals without violating loading, setup, and hold times of the asynchronous clock divider. For example, in some embodiments, a high-speed frequency divider in accordance with one or more embodiments of the present disclosure may generate a reduced frequency clock by dividing the input signal by a clock reduction factor. The reduced frequency clock may then be provided to the asynchronous clock divider of the high-speed frequency divider. Using a reduced frequency clock at the asynchronous clock divider may enable proper loading of initial programmed counts in the asynchronous clock divider, even when the input signal is operating at high frequencies.

As further described herein, reducing the frequency of the input signal by a clock reduction factor requires modification to the initial programmed count loaded into the asynchronous clock divider. In a traditional asynchronous clock divider, the programmed count may be directly based on the desired division factor at the frequency divider. For example, to divide by five, an initial value of five may be loaded into the asynchronous clock divider for each half of a clock cycle (or three for an n-plus-two divider). Similarly, in a two-stage divide-by-two divider, in which a divide-by-two is performed after the asynchronous clock divider, the programmed count may be divided by two and provided as the initial value.

Here, since we have reduced the frequency of the input signal by a clock reduction factor, the programmed count may be determined by dividing the desired frequency division factor by the clock reduction factor. In an instance in which a divide-by-two stage is added to the output of the high-speed frequency divider, the programmed count may be determined by dividing the desired frequency division factor by two-times the clock reduction factor.

The high-speed frequency divider described herein may further utilize a plurality of clock phases based on the reduced frequency clock to generate the output signal. In some embodiments, a plurality of phases of the reduced frequency clock may be generated and transmitted to clock selection circuitry. The number of phases in the plurality of phases may be determined based on the clock reduction factor. For example, in an instance in which the clock reduction factor is four, four phases of the reduced frequency clock may be provided to the clock selection circuitry. The selection signal may determine which phase of the reduced frequency clock is used to generate the output signal. The selection signal may be based on the frequency division factor, the output signal, and the plurality of phases of the reduced frequency clock.

Additional logic may be leveraged to determine an initial programmed count in an instance in which the frequency division factor is not an exact division, for example, in an instance in which dividing the frequency division factor by two times the clock reduction factor results in a remainder (e.g., integer division remainder). In such an instance, the remainder may be accumulated by remainder accumulation circuitry. Once the accumulated integer division remainder equals one, the initial programmed count is incremented for one generation cycle.

As a result of the herein described example embodiments and in some examples, the operation of a frequency divider may be enabled at higher input signal frequencies. In addition, improvements to the accuracy and reliability of output signal generation at a frequency divider may be improved.

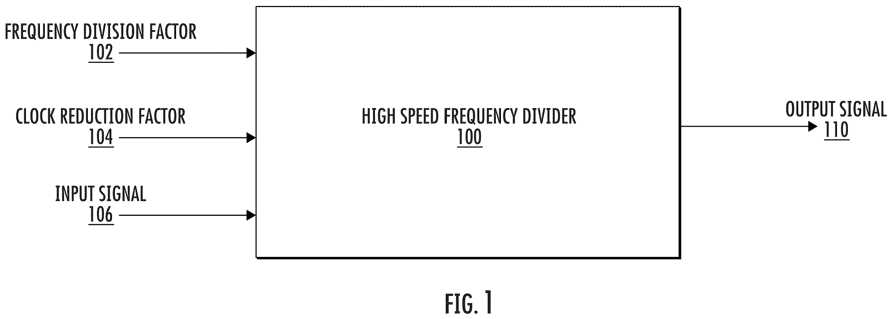

Referring now to FIG. 1, an example high-speed frequency divider 100 is provided. As depicted in FIG. 1, the example high-speed frequency divider 100 is configured to receive an input signal 106, a clock reduction factor 104, and a frequency division factor 102. The high-speed frequency divider 100 is configured to generate an output signal 110 based on these inputs.

In general, a high-speed frequency divider 100 is configured to receive an input signal 106 operating in accordance with a certain reference frequency, and generate an output signal 110 at a lower frequency based on a frequency division factor 102. For example, in an instance in which the input signal 106 oscillates at a frequency of five gigahertz, and a frequency division factor 102 of five is provided, the high-speed frequency divider 100 generates an output signal 110 oscillating at a frequency of one gigahertz.

As depicted in FIG. 1, the high-speed frequency divider 100 is configured to receive an input signal 106. An input signal 106 comprises any time-varying digital voltage or current configured to convey information in an electrical system. The input signal 106 is configured to oscillate according to a reference frequency (e.g., 5 gigahertz).

In some embodiments, the input signal 106 may comprise a digital signal configured to occupy one of two states. Throughout the description, the two states of a digital signal may be described as a logical high state or a logical low state. A digital signal is at a logical high state when an electrical characteristic of the digital signal is above a logical threshold. For example, an instance in which a voltage of the digital signal exceeds a logical threshold voltage. A digital signal is at a logical low state when an electrical characteristic of the digital signal is below a logical threshold. For example, an instance in which a voltage of the digital signal is below a logical threshold voltage. The logical states of a digital signal may also be indicated by 0 (e.g., logical low state) and 1 (e.g., logical high state) as used interchangeably throughout.

When referencing a digital signal, the term "asserted/de-asserted" refers to the logical state of the digital signal when the digital signal is active. An active high digital signal is in an asserted state in an instance in which the digital signal is in a logical high state, and in a de-asserted state in an instance in which the digital signal is in a logical low state. An active low digital signal is an asserted state in an instance in which the digital signal is in a logical low state, and in a de-asserted state in an instance in which the digital signal is in a logical high state.

Digital signals may transition from one logical state to another. A transition from a logical low state to a logical high state may be referred to as a rising edge of the digital signal. A transition from a logical high state to a logical low state may be referred to as a falling edge of the digital signal. A triggering edge refers to the transition of the digital signal that causes an action in an electronic device. A triggering edge may refer to either a rising edge or a falling edge. For example, in some embodiments, a state machine may transition states based on a rising edge, while in other embodiments a state machine may transition states based on a falling edge. In such an instance, the edge of the digital signal causing the transition may be referred to as the triggering edge

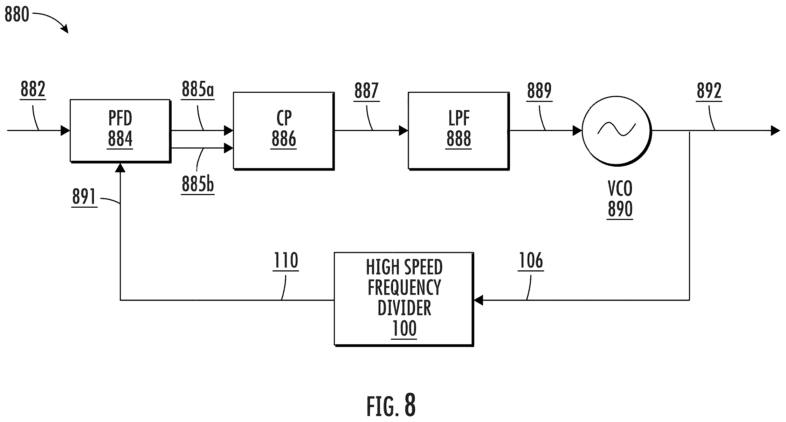

In some embodiments, the input signal 106 may be a generated output signal fed back to the input of an electrical system for comparison. For example, the input signal 106 may comprise a phase-locked signal generated by a phase-locked loop. In a phase-locked loop, the phase-locked signal (e.g., input signal 106) generated by the phase-locked loop may be fed back to the high-speed frequency divider 100. When positioned to receive the phase-locked signal in the feedback path of a phase-locked loop, the high-speed frequency divider 100 enables frequency synthesis, scaling, and stability in the phase-locked signal in relation to the reference signal provided to the phase-locked loop. For example, to generate a phase-locked signal based on the reference signal, but scaled to a higher frequency, the high-speed frequency divider 100 may generate an output signal 110 at a reduced frequency of the phase-locked signal (e.g., reduced by a frequency division factor 102). The reduced frequency feedback signal (e.g., output signal 110) is compared to the reference signal, and the frequency of the phase-locked signal is adjusted based on the comparison. An example phase-locked loop is described further in relation to FIG. 8.

As further depicted in FIG. 1, the high-speed frequency divider 100 is configured to receive a frequency division factor 102. A frequency division factor 102 comprises any integer value for determining the relation of the frequency of the output signal 110 to the reference frequency of the input signal 106. For example, the frequency of the output signal 110 may be determined by dividing the reference frequency of the input signal 106 by the frequency division factor 102. In such an example, in an instance in which the reference frequency of the input signal 106 is six gigahertz, and the frequency division factor 102 is nine, the frequency of the output signal 110 is (6 / 9 = 0.667) 0.667 gigahertz.

In an instance in which a high-speed frequency divider 100 is positioned in the feedback path of a phase-locked loop, adjusting the frequency division factor 102 of the high-speed frequency divider 100, the phase-locked loop can effectively multiply the reference signal to generate a stable phase-locked signal at a higher frequency than the reference signal. For example, if the desired frequency of the phase-locked signal is ten gigahertz and the reference signal oscillates at one gigahertz, the frequency division factor 102 may be set to ten, enabling the phase-locked loop to lock the phase-locked signal at 10 gigahertz.

The high-speed frequency divider 100 further supports dynamic updates to the frequency division factor 102. Thus, the frequency division factor 102 may be updated during operation to alter the relative frequency of the output signal 110. Dynamic switching of the frequency division factor 102 may be utilized in various applications, such as telecommunication applications, radar chirp applications, and so on.

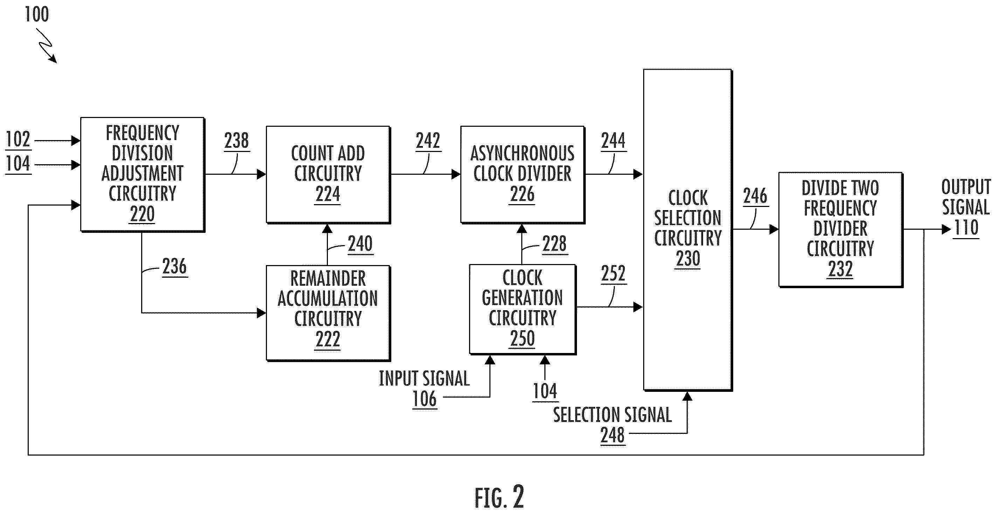

As further depicted in FIG. 1, the high-speed frequency divider 100 is configured to receive a clock reduction factor 104. A clock reduction factor 104 is any value for determining the relation of the frequency of the input signal 106 to the frequency of the reduced frequency clock provided to the asynchronous clock divider of the high-speed frequency divider 100. For example, in an instance in which the input signal 106 oscillates according to a reference frequency of five gigahertz and a clock divider of four is specified, the reduced frequency clock provided to the asynchronous clock divider of the high-speed frequency divider 100 oscillates at a frequency of (5/4 = 1.25) 1.25 gigahertz. By reducing the frequency of the clock provided to the asynchronous clock divider (e.g., reduced frequency clock 228 as depicted in FIG. 2) many of the problems associated with operating a high-speed frequency divider 100 at high frequencies (e.g., any frequency resulting in incorrect division factor, for example, due to failure of proper loading due to timing issue) are resolved. For example, reducing the frequency of the reduced frequency clock provided to the asynchronous clock divider increases the loading time available for loading the initial programmed count into the asynchronous clock divider. Further, reducing the frequency of the reduced frequency clock may decrease the total time of the critical path, enabling the system to operate at higher frequencies.

Referring now to FIG. 2, a block diagram of an example high-speed frequency divider 100 is provided. As depicted in FIG. 2, the high-speed frequency divider 100 includes frequency division adjustment circuitry 220, remainder accumulation circuitry 222, count add circuitry 224, an asynchronous clock divider 226, clock selection circuitry 230, frequency divider circuitry 232, and clock generation circuitry 250.

As depicted in FIG. 2, the frequency division adjustment circuitry 220 is configured to receive and/or store the frequency division factor 102, the clock reduction factor 104, and the output divide factor of two, and the output signal 110, and perform an integer division operation to generate an integer division quotient 238 and an integer division remainder 236. The remainder accumulation circuitry 222 receives the integer division remainder 236 and generates an accumulated integer division remainder 240. The count add circuitry 224 receives the integer division quotient 238 and the accumulated integer division remainder and generates an initial programmed count 242 for the asynchronous clock divider 226.

As further depicted in FIG. 2, the clock generation circuitry 250 is configured to receive the input signal 106 and generate a reduced frequency clock 228 transmitted to the asynchronous clock divider 226, and a plurality of phases 252 of the reduced frequency clock 228. As further depicted in FIG. 2, the asynchronous clock divider 226 is configured to receive the initial programmed count 242 and the reduced frequency clock 228 and generate a frequency divided signal 244. The clock selection circuitry 230 is configured to receive the plurality of phases 252 of the reduced frequency clock 228, the frequency divided signal 244, and a selection signal 248, and generate a clock selection output signal 246. The frequency divider circuitry 232 is configured to receive the clock selection output signal 246 and generate the output signal 110 based on an output divide factor. As described herein, the output divide factor is fixed at two, although in some embodiments, the output divide factor may be another power of two (e.g., 4, 8, 16, etc.).

As depicted in FIG. 2, the high-speed frequency divider 100 includes clock generation circuitry 250. The clock generation circuitry 250 comprises any circuitry including hardware and/or software configured to receive an input signal 106 and generate a reduced frequency clock 228 and a plurality of phases 252 of the reduced frequency clock 228 based on a clock reduction factor 104. The clock reduction factor 104 comprises any value for determining the relation of the frequency of the input signal 106 to the frequency of the reduced frequency clock 228 provided to the asynchronous clock divider 226. The clock reduction factor 104 may be determined based on the reference frequency of the input signal 106, the frequency division factor 102, the components of the high-speed frequency divider 100, and/or other factors. For example, in some embodiments, the clock reduction factor 104 may be selected to reduce the clock frequency (e.g., reduced frequency clock 228) operating the asynchronous clock divider 226. Reducing the clock frequency of the asynchronous clock divider 226 may increase the loading time of the initial programmed count 242 at the asynchronous clock divider 226. Further, higher frequency input signals 106 may be supported by reducing the frequency of the reduced frequency clock 228 provided to the asynchronous clock divider 226.

In some embodiments, the clock reduction factor 104 may be selected to simplify determination of the reduced frequency clock 228. For example, the clock reduction factor 104 may be associated with a power of two (e.g., 2, 4, 8, 16). Frequency reduction of a signal (e.g., input signal 106) may be simplified in an instance in which the frequency reduction factor is limited to a power of two. For example, a series of flip-flops may be configured to output a reduced frequency clock 228 with a frequency reduced by a power of two from the input signal 106 without requiring any loading.

In some embodiments, the high-speed frequency divider may operate without receiving a clock reduction factor as an input. Instead, a designer may determine a fixed reduction of the input signal 106 by a factor of $2^n$ to ensure proper operation of the asynchronous clock divider 226. The value of n may be selected based on design requirements, and the frequency division factor 102 is partitioned accordingly. Specifically, the least significant bits (LSBs) and most significant bits (MSBs) of the frequency division factor are derived from the value of n, wherein the LSB portion, comprising (n+1) bits, is provided to the remainder accumulation circuitry 222 and the clock selection circuitry 230, while the MSB portion is used to determine the initial programmed count 242 for the asynchronous clock divider 226. For example, if the frequency division factor 102 is a 6-bit value "101001" and the input signal is reduced by $2^1$ (e.g., n = 1), then n+1 = 2 bits of LSBs ("01") are routed to the remainder accumulation circuitry 222 and clock selection circuitry 230, and the remaining MSBs ("1010") are used for the initial programmed count 242. Such an approach eliminates the need for a separate clock reduction factor 104 input while maintaining accurate division and phase selection.

In addition to generating the reduced frequency clock 228, the clock generation circuitry 250 may be further configured to generate a plurality of phases 252 of the reduced frequency clock 228. The number of phases comprising the plurality of phases 252 may depend on the clock reduction factor 104. For example, in an instance in which an input signal is reduced by a clock reduction factor 104, the reduced frequency clock 228 may exhibit a number of phases equal to the clock reduction factor 104. For example, if the clock reduction factor 104 is four, the reduced frequency clock 228 may exhibit one of four phases. The clock generation circuitry 250 generates each of the possible phases of the plurality of phases 252 and transmits the plurality of phases 252 to the clock selection circuitry 230. Thus, each of the phases comprising the plurality of phases 252 oscillates at the frequency of the reduced frequency clock 228 but is offset from the previous phase of the plurality of phases 252 by a clock cycle of the input signal 106.

As further depicted in FIG. 2, the high-speed frequency divider 100 includes frequency division adjustment circuitry 220. The frequency division adjustment circuitry 220 is any circuitry including hardware and/or software configured to perform an integer division operation and generate an integer division quotient 238 and an integer division remainder 236 based on the integer division operation. In general, the purpose of the frequency division adjustment circuitry 220 is to adjust the frequency division factor 102 to generate the desired output signal 110 based on the configuration of the high-speed frequency divider 100. For example, the frequency division factor 102 is adjusted based on the clock reduction factor 104 and the output divide factor of two.

In one example, the integer division operation is performed according to Equation (1) below:

$$(1) \quad Q = \frac{NDIV}{2 \cdot P}$$

where Q is the integer division quotient 238, *NDIV* is the frequency division factor 102, the output divide factor is 2, and P is the clock reduction factor 104. By performing the integer division operation on the frequency division factor 102 of the high-speed frequency divider 100 essentially adjusts the initial programmed count 242 loaded into the asynchronous clock divider 226 based on the fact that the asynchronous clock divider 226 is operated according to a reduced frequency clock 228. Further, performing the integer division operation on the frequency division factor 102 of the high-speed frequency divider 100 adjusts the initial programmed count 242 based on the additional frequency divide by two operation performed at the frequency divider circuitry 232.

The frequency division adjustment circuitry 220 generates an integer division quotient 238 and an integer division remainder 236. The integer division quotient 238 is the result of the integer division operation without any fractional part. The integer division remainder 236 is the remainder of the integer division operation. For example, in an instance in which the frequency division factor 102 is nine, the output divide factor is two, and the clock reduction factor 104 is two, the integer division quotient 238 is (9/4 = 2.25) two, and the integer division remainder is one-fourth (0.25).

As further depicted in FIG. 2, the frequency division adjustment circuitry 220 is configured to update the integer division quotient 238 and the integer division remainder 236 based on the output signal 110. Utilizing the output signal 110 to update the initial programmed count 242 enables dynamic updates to the frequency of the output signal. For example, in some embodiments, the new integer division quotient 238 and the integer division remainder 236 may be determined at the falling edge of the output signal 110. Dynamic updates to the initial programmed count 242 enable the high-speed frequency divider 100 to be programmable. A programmable high-speed frequency divider 100 may be especially useful with applications requiring an output signal with a time-changing frequency, such as a chirp signal in a radar application. For example, when utilized in the feedback path of a phase-locked loop, a programmable high-speed frequency divider 100 may enable continually updates to the output frequency of the phase-locked signal by changing the frequency division factor 102 provided to the high-speed frequency divider 100.

As further depicted in FIG. 2, the high-speed frequency divider 100 includes remainder accumulation circuitry 222. The remainder accumulation circuitry 222 is any circuitry comprising hardware and/or software configured to accumulate the integer division remainder 236 at each cycle generation of the output signal 110. The remainder accumulation circuitry 222 may comprise an integrator, such as a modulo integrator. The remainder accumulation circuitry 222 updates based on the integer division remainder 236 at each cycle. In an instance in which the accumulated integer division remainder 240 equals or exceeds one, a one is output to the count add circuitry 224 and the accumulated integer division remainder 240 is reset.

As further depicted in FIG. 2, the count add circuitry 224 is any circuitry including hardware and/or software configured to generate an initial programmed count 242 based on the integer division quotient 238 and the integer division remainder 236. In some embodiments, the count add circuitry 224 increments the integer division quotient 238 in an instance in which the accumulated integer division remainder 240 is equal to or greater than one. Thus, the initial programmed count 242 is updated to account for integer division operations generating an integer division remainder 236, for example, (9/4 = 2.25).

As further depicted in FIG. 2, the high-speed frequency divider 100 includes an asynchronous clock divider 226. The asynchronous clock divider 226 comprises any circuitry including hardware and/or software configured to receive an initial programmed count 242 and generate a frequency divided signal 244 based on the initial programmed count 242 and the reduced frequency clock 228. In some embodiments, the asynchronous clock divider 226 may comprise a plurality of series-connected flip-flops, for example, d-type flip-flops. In such an embodiment, the reduced frequency clock 228 may be connected to the clock terminal of a first d-type flip-flop, and the inverse output terminal may be connected to the data input terminal. The output terminal is then connected to the clock terminal of a second d-type flip-flop. The pattern continues wherein each d-type flip-flop represents a bit in the count value.

The asynchronous clock divider 226 may count up or down and update the output in an instance in which the count terminates. In an example embodiment, the asynchronous clock divider 226 may be pre-loaded with a programmed count (e.g., initial programmed count 242). With each rising edge of the reduced frequency clock 228, the programmed count is decremented. In an instance in which the programmed count reaches zero, the frequency divided signal 244 may be asserted. In a one-shot asynchronous clock divider 226, the frequency divided signal 244 is asserted for one clock cycle every time the programmed count reaches zero. Once the programmed count reaches zero, and the frequency divided signal 244 is asserted, the initial programmed count 242 is reloaded into the asynchronous clock divider 226 and the count is updated with the next arrival of the reduced frequency clock 228. By asserting or otherwise updating the frequency divided signal 244 only after the count has expired, the frequency divided signal 244 oscillates, or causes oscillation at a reduced frequency.

In some embodiments, the asynchronous clock divider 226 may comprise a additional setup or output stages that require updating the initial programmed count 242 before loading the value into the asynchronous clock divider 226. For example, in an N+2 clock divider, the initial programmed count 242 is reduced by two before loading the initial programmed count 242 into the asynchronous clock divider 226 circuitry.

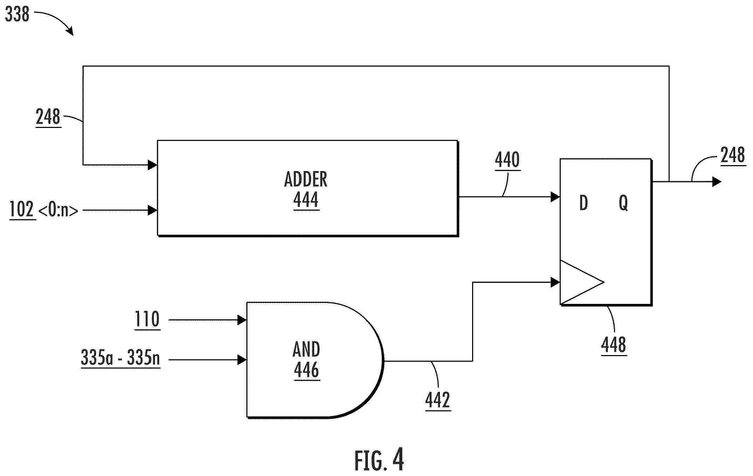

As further depicted in FIG. 2, the high-speed frequency divider 100 includes clock selection circuitry 230. The clock selection circuitry 230 selects a clock from the plurality of phases 252 of the reduced frequency clock 228 to define the transitions of the output signal 110. By selecting from a plurality of phases 252 of the reduced frequency clock 228, the high-speed frequency divider 100 may account for integer division operations performed at the frequency division adjustment circuitry 220. For example, in some embodiments, the selection signal 248 may be updated to select a clock from the plurality of phases 252 based on the integer division remainder 236 generated by the frequency division adjustment circuitry 220. In some embodiments, the selection signal 248 may be updated based on one or more least significant bits of the frequency division factor 102. For example, when the one or more least significant bits of the frequency division factor 102 are all LOW, in that case there will be no change in the selection signal 248. However, when the one or more least significant bits of the frequency division factor 102 are greater than 0, the election signal 248 will be updated with every rising edge of the select enable signal (e.g., select enable signal 442 described in relation to FIG. 4). In general, the clock selection circuitry 230 selects the clock signal from the plurality of phases 252 of the reduced frequency clock 228 to adjust the clock selection output signal 246 based on the integer division remainder 236 of the integer division operation performed at the frequency division adjustment circuitry 220.

In addition, in some embodiments, the selection signal 248 may be updated at the falling edge of the output signal 110. Thus, the selection signal 248 is updated in time for the next rising edge of the output signal 110. Example selection signal circuitry is further described in relation to FIG. 4.

As further depicted in FIG. 2, the example high-speed frequency divider 100 includes frequency divider circuitry 232. The frequency divider circuitry 232 comprises any circuitry including hardware and/or software configured to further divide the clock selection output signal by an output divide factor to generate the output signal 110. As described herein, the output divide factor is fixed at two, however, in some embodiments, the output divide factor may be set to another power of two (e.g., 4, 8, 16, etc.). In an instance in which the output divide factor is changed, the integer division operation and determination of the selection signal 248 may also be updated. Dividing my a power of two may be easily implemented with series-connected flip-flops without loading values.

By utilizing the frequency divider circuitry 232 at the output of the high-speed frequency divider 100, the frequency divide operation performed by the asynchronous clock divider 226 may be reduced and simplified. For example, a divide by two operation may be performed resulting in a 50% output clock duty cycle. Since the signal generated by the asynchronous clock divider 226 is further divided by the frequency divider circuitry 232, the initial programmed count 242 must be adjusted based on the output divide factor of two. Thus, the frequency division adjustment circuitry 220 compensates for the output divide factor of two in determining the integer division quotient 238 and the integer division remainder 236.

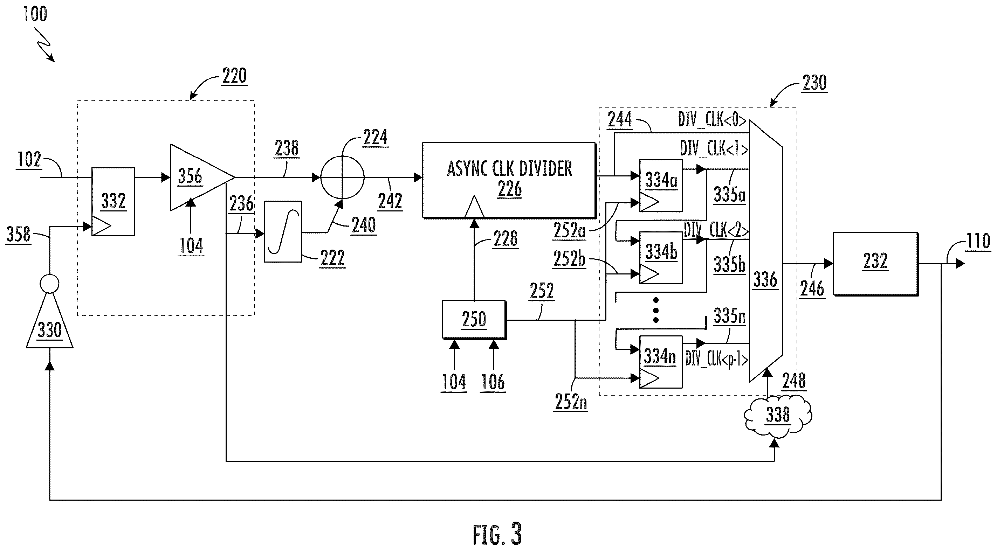

Referring now to FIG. 3, an example embodiment of a high-speed frequency divider 100 is provided. As depicted in FIG. 3, the example high-speed frequency divider 100 includes an asynchronous clock divider 226 configured to receive an initial programmed count 242 from count add circuitry 224, and a reduced frequency clock 228 from clock generation circuitry 250, wherein the reduced frequency clock 228 is based on an input signal 106 and a clock reduction factor 104. The clock generation circuitry 250 is further configured to generate a plurality of phases 252 of the reduced frequency clock 228.

As further depicted in FIG. 3, the high-speed frequency divider 100 further includes clock selection circuitry 230 configured to receive the frequency divided signal 244 from the asynchronous clock divider 226, the plurality of phases 252 of the reduced frequency clock 228, and a selection signal 248 from selection signal circuitry 338, and generate a clock selection output signal 246.

The clock selection output signal 246 is generated based on the selection signal 248 generated by the selection signal circuitry 338. In general, the selection signal circuitry 338 is configured to select a selected clock signal corresponding with one of the plurality of phases 252 of the reduced frequency clock 228. The selection signal 248 generated by the selection signal circuitry 338 may enable the high-speed frequency divider 100 to compensate for utilizing a reduced frequency clock 228 at the asynchronous clock divider 226. For example, the selection signal 248 enables the output signal 110 to be based on a phase offset of the reduced frequency clock 228 corresponding with a clock cycle of the input signal 106. Example selection signal circuitry 338 is described in relation to FIG. 4.

As depicted in FIG. 3, the plurality of phases 252 include a first phase offset 252a, a second phase offset 252b, and so on to the last phase offset 252n. The number of phase offsets 252a - 252n is dependent on the clock reduction factor 104. For example, the number of phase offsets 252a - 252n may correspond to the clock reduction factor 104 minus one. For example, in an instance in which the clock reduction factor 104 is four, there are three phase offsets. In such an example, the frequency divided signal 244 corresponds to the reduced frequency clock 228 with no phase offset, the first phase offset 252a corresponds to the reduced frequency clock 228 offset by one cycle of the higher frequency input signal 106 with reference to the frequency divided signal 244, the second phase offset 252b corresponds to the reduced frequency clock 228 offset by one cycle of the higher frequency input signal 106 with reference to the first phase offset 252a, and the third phase offset (e.g., last phase offset 252n) corresponds to the reduced frequency clock 228 offset by one cycle of the higher frequency input signal 106 with reference to the second phase offset 252b.

As further depicted in FIG. 3, the clock selection circuitry 230 includes a first flip-flop 334a, a second flip-flop 334b, and a representative last flip-flop 334n. The number of flip-flops in the clock selection circuitry 230 is dependent upon the number of phases of the reduced frequency clock 228 provided by the clock generation circuitry 250 and thus dependent on the clock reduction factor 104 by which the input signal 106 is reduced. In some embodiments, the number of flip-flops in the clock selection circuitry 230 is equal to the clock reduction factor 104 minus one. The data terminal of the first flip-flop 334a is electrically connected to the asynchronous clock divider 226 and configured to receive the frequency divided signal 244. The first flip-flop 334a generates a first shifted frequency divided signal 335a, representing the frequency divided signal 244, however, shifted to be synchronized with the triggering edge (e.g., rising edge) of the first phase offset 252a. The first shifted frequency divided signal 335a is provided to the clock selection mux 336 as a selectable output. In an instance in which the selection signal 248 corresponds with the first shifted frequency divided signal 335a, the first shifted frequency divided signal 335a is output as the clock selection output signal 246.

The output terminal of the first flip-flop 334a is further electrically connected to the data terminal of the second flip-flop 334b, providing the first shifted frequency divided signal 335a to the data terminal of the second flip-flop 334b. The second flip-flop 334b generates a second shifted frequency divided signal 335b, representing the frequency divided signal 244, however, shifted to be synchronized with the triggering edge (e.g., rising edge) of the second phase offset 252b. The second shifted frequency divided signal 335b is provided to the clock selection mux 336 as a selectable output. In an instance in which the selection signal 248 corresponds with the second shifted frequency divided signal 335b, the second shifted frequency divided signal 335b is output as the clock selection output signal 246.

Such a pattern continues for each of the flip-flops in the clock selection circuitry 230.

As further depicted in FIG. 3, the output terminal of the next to last flip-flop (e.g., not shown) is further electrically connected to the data terminal of the last flip-flop 334n, providing the next to last shifted frequency divided signal to the data terminal of the last flip-flop 334n. The last flip-flop 334n generates a last shifted frequency divided signal 335n, representing the frequency divided signal 244, however, shifted to be synchronized with the triggering edge (e.g., rising edge) of the last phase offset 252n. The last shifted frequency divided signal 335n is provided to the clock selection mux 336 as a selectable output. In an instance in which the selection signal 248 corresponds with the last shifted frequency divided signal 335n, the last shifted frequency divided signal 335n is output as the clock selection output signal 246.

As further depicted in FIG. 3, the output of the asynchronous clock divider 226 is also electrically connected to the clock selection mux 336 as a selectable output. The frequency divided signal 244 represents an unshifted division of the reduced frequency clock 228. In an instance in which the selection signal 248 corresponds with the frequency divided signal 244, the frequency divided signal 244 is output as the clock selection output signal 246. Within the clock selection circuitry, the frequency divided signal 244 may be considered the $0^{th}$ shifted frequency divided signal.

As further depicted in FIG. 3, the high-speed frequency divider 100 further includes frequency divider circuitry 232 configured to receive the clock selection output signal 246, and generate the output signal 110 by dividing the clock selection output signal 246 by an output divide factor of two. In some embodiments, the frequency divider circuitry 232 may be configured to divide the clock selection output signal 246 by another power of two (e.g., 4, 8, 16, 32). Dividing my a power of two may be easily implemented with series-connected flip-flops without providing further timing constraints by loading values.

As further depicted in FIG. 3, the high-speed frequency divider 100 includes frequency division adjustment circuitry 220. The frequency division adjustment circuitry 220 is configured to receive an inverted output signal 358 from an inverter 330, the frequency division factor 102, and the clock reduction factor 104, and generate an integer division quotient 238 and an integer division remainder 236.

As depicted in FIG. 3, the frequency division adjustment circuitry 220 comprises an input flip-flop 332 configured to latch any changes to the frequency division factor 102 with the falling edge (e.g., rising edge of the inverted output signal 358) of the output signal 110. Thus, changes to the frequency division factor 102 of the high-speed frequency divider 100 may be provided dynamically, and any changes to the frequency division factor 102 will be implemented once the generation of the current cycle of the output signal 110 is complete.

The frequency division adjustment circuitry 220 further includes an integer division circuit 356 configured to perform an integer divide operation. The dividend of the integer divide operation is the frequency division factor 102 as latched by the input flip-flop 332. The divisor of the integer divide operation is the product of the clock reduction factor 104 and the output divide factor which is fixed at two. Although the output divide factor is fixed at two in the present description, in some examples, the output divide factor may be set to any power of two. In some examples, the clock reduction factor 104 is a power of two, thus, dividing the frequency division factor 102 requires only shifting the bits of the frequency division factor 102, wherein the integer division quotient 238 comprises the remaining bits after shifting, and the integer division remainder 236 comprises the bits that are lost in shifting.

As further depicted in FIG. 3, the high-speed frequency divider 100 includes remainder accumulation circuitry 222 configured to accumulate the integer division remainder 236 generated by the frequency division adjustment circuitry 220. The remainder accumulation circuitry 222 may comprise a modulo integrator. In an instance in which the accumulated remainder at the remainder accumulation circuitry 222 equals or exceeds one, a one may be output as the accumulated integer division remainder 240, and the accumulated remainder reset.

As further depicted in FIG. 3, the count add circuitry 224 is configured to generate the initial programmed count 242 based on a summation of the integer division quotient 238 and an accumulated integer division remainder 240, wherein the accumulated integer division remainder 240 is added to the integer division quotient 238 in an instance in which the accumulated integer division remainder 240 is greater than or equal to one.

Referring now to FIG. 4, example selection signal circuitry 338 of an example high-speed frequency divider 100 is provided. As depicted in FIG. 4, the selection signal circuitry 338 includes an adder 444, an AND gate 446, and at least one select flip-flop 448. The adder 444 is configured to receive the current selection signal 248 and one or more least significant bits 102<0:n> of the frequency division factor (e.g., frequency division factor 102). The number of least significant bits 102<0:n> depends on the number of shifted frequency divided signals 335a - 335n generated within the clock selection circuitry (e.g., clock selection circuitry 230), and thus, also depends on the clock reduction factor (e.g., clock reduction factor 104) used to generate the reduced frequency clock (e.g., reduced frequency clock 228). For example, the number of least significant bits 102<0:n> may be equivalent to the base-2 log of the clock reduction factor. Increasing the number of least significant bits 102<0:n> may limit the division factor at the lower side, meaning lower division may not be possible.

As depicted in FIG. 4, the adder 444 is configured to add the least significant bits 102<0:n> to the current selection signal 248 to generate the next selected signal 440. For example, in an instance in which the clock selection circuitry 230 includes the frequency divided signal 244 and a first shifted frequency divided signal 335a; the least significant bit of the frequency division factor is one; and the output divide factor is two, the selection signal 248 toggles between one and zero between output signal 110 generation cycles. Similarly, in an instance in which the clock selection circuitry 230 includes the frequency divided signal 244 and three shifted frequency divided signals, the selection signal circuitry 338 is configured to receive the two least significant bits of the frequency division factor, and four shifted frequency divided signals (e.g., 0th through 3rd). The two least significant bits of the frequency division factor are added to the current selection signal 248 to generate the next selected signal 440 between output signal 110 generation cycles. For example, in an instance in which the two least significant bits 102<0:n> are "10" the selection signal 248 may toggle between "00" and "10" between output signal 110 generation cycles.

As further depicted in FIG. 4, the AND gate 446 is configured to receive the output signal 110, and each of the shifted frequency divided signals 335a - 335n (including the frequency divided signal 244), and generate a select enable signal 442 in an instance in which each of the inputs is high. By generating the select enable signal 442 based on the output signal 110 and each of the shifted frequency divided signals 335a- 335n (including the frequency divided signal 244), the selection signal 248 is updated after the rising edge of the output signal 110 (e.g., the rising edge of the output signal after delay of AND (446), clock to Q delay of flip-flop).

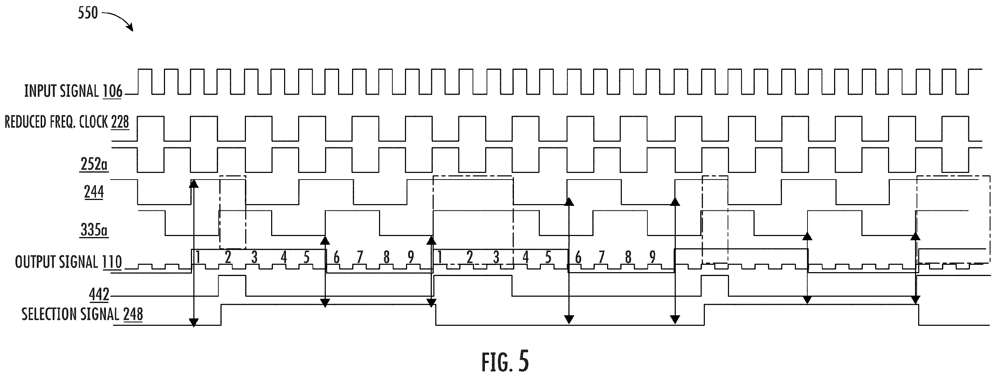

Referring now to FIG. 5, an example signal diagram 550 depicting a divide-by-9 operation (e.g., frequency division factor is equal to "1001") on an example high-speed frequency divider 100 designed in accordance with an example embodiment of the present disclosure, is provided.

The example signal diagram 550 depicted in FIG. 5, is based on a high-speed frequency divider 100 having an input signal 106; a clock reduction factor 104 of two to generate the reduced frequency clock 228, a frequency division factor 102 of nine; and an output divide factor of two. As depicted in FIG. 5, the input signal 106 oscillates at a reference frequency, and the reduced frequency clock 228 oscillates at a reduced frequency, one-half of the reference frequency. In the example high-speed frequency divider 100 of the present disclosure, the reduced frequency clock 228 is provided to the asynchronous clock divider 226. As further depicted in FIG. 5, a first phase offset 252a of the reduced frequency clock 228 is provided.

Since the clock reduction factor 104 is set to two, the clock selection circuitry 230 is configured to select between a frequency divided signal 244 (e.g., 0th shifted frequency divided signal) as output by the asynchronous clock divider 226, and a first shifted frequency divided signal 335a based on the output of the first flip-flop 334a in coordination with the first phase offset 252a of the reduced frequency clock 228.

As further depicted in FIG. 5 the select enable signal 442 is asserted in an instance in which the output signal is high, along with both the frequency divided signal 244 (e.g., 0th shifted frequency divided signal) and the first shifted frequency divided signal 335a. In an instance in which the select enable signal 442 is asserted, the selection signal 248 is updated based on the next selected signal 440. For example, as depicted in FIG. 5, the selection signal 248 toggles between one and zero, based on the least significant bit of the frequency division factor 102 (e.g., "1").

As depicted in FIG. 5, the rising edge of the output signal 110 switches between the frequency divided signal 244 (e.g., 0th shifted frequency divided signal) and the first shifted frequency divided signal 335a based on the selection signal 248.

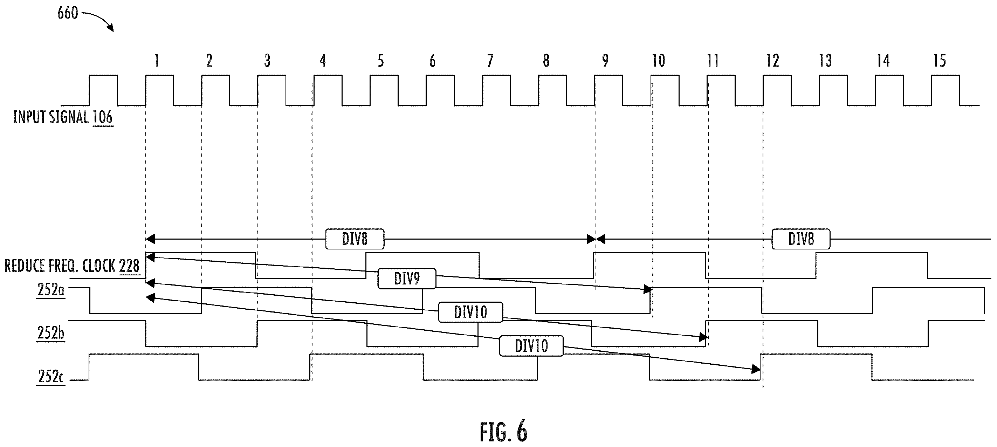

Referring now to FIG. 6, an example signal diagram 660 depicting a plurality of divide operations on an example high-speed frequency divider 100 designed in accordance with an example embodiment of the present disclosure, is provided.

The example signal diagram 660 depicted in FIG. 6, is based on a high-speed frequency divider 100 having an input signal 106; a clock reduction factor 104 of four to generate the reduced frequency clock 228; and an output divide factor of two. As depicted in FIG. 6, the input signal 106 oscillates at a reference frequency, and the reduced frequency clock 228 oscillates at a reduced frequency, one-quarter of the reference frequency. In the example high-speed frequency divider 100 of the present disclosure, the reduced frequency clock 228 is provided to the asynchronous clock divider 226, thus the asynchronous clock divider is operating at one-quarter the frequency of the input signal 106. As further depicted in FIG. 5, a first phase offset 252a, a second phase offset 252b, and a third phase offset 252c of the reduced frequency clock 228 are provided and shown as offset from the reduced frequency clock 228.

The example signal diagram 660 shows the general operation of a divide-by-8 operation (e.g., frequency division factor is equal to "1000"), a divide-by-9 operation (e.g., frequency division factor is equal to "1001"), a divide-by-10 operation (e.g., frequency division factor is equal to "1010"), and a divide-by-11 operation(e.g., frequency division factor is equal to "1011"), relative to the plurality of phases 252 of the reduced frequency clock 228.

As depicted in FIG. 6, in an instance in which a divide-by-8 operation (e.g., frequency division factor is equal to "1000") is performed, the rising and falling edges of the output signal (not pictured) are always defined by the reduced frequency clock 228. Such behavior occurs since the two least significant bits of the frequency division factor are "00." Thus, the selection signal at the clock selection mux remains "00."

As further depicted in FIG. 6, in an instance in which a divide-by-9 operation (e.g., frequency division factor is equal to "1001") is performed, the rising and falling edges of the output signal (not pictured) cycle between each of the plurality of phases 252 of the reduced frequency clock 228 in order. For example, the first edge is defined by the reduced frequency clock 228; the second edge is defined by the first phase offset 252a of the reduced frequency clock 228; the third edge is defined by the second phase offset 252b of the reduced frequency clock 228; and so on. Such behavior occurs since the two least significant bits of the frequency division factor are "01." Thus, the selection signal is incremented by "01" at the outset of the second half of each cycle of the output signal 110.

As further depicted in FIG. 6, in an instance in which a divide-by-10 operation (e.g., frequency division factor is equal to "1010") is performed, the rising and falling edges of the output signal (not pictured) toggle between the reduced frequency clock 228 and the second phase offset 252b of the reduced frequency clock 228; and so on. Such behavior occurs since the two least significant bits of the frequency division factor are "10." Thus, the selection signal is incremented by "10" at the outset of the second half of each cycle of the output signal 110.

As further depicted in FIG. 6, in an instance in which a divide-by-11 operation (e.g., frequency division factor is equal to "1011") is performed, the rising and falling edges of the output signal (not pictured) cycle between each of the plurality of phases 252 of the reduced frequency clock 228 in reverse order. For example, the first edge is defined by the reduced frequency clock 228; the second edge is defined by the third phase offset 252c of the reduced frequency clock 228; the third edge is defined by the second phase offset 252b of the reduced frequency clock 228; the fourth edge is defined by the first phase offset 252a of the reduced frequency clock 228; and so on. Such behavior occurs since the two least significant bits of the frequency division factor are "11." Thus, the selection signal is incremented by "11" at the outset of the second half of each cycle of the output signal 110.

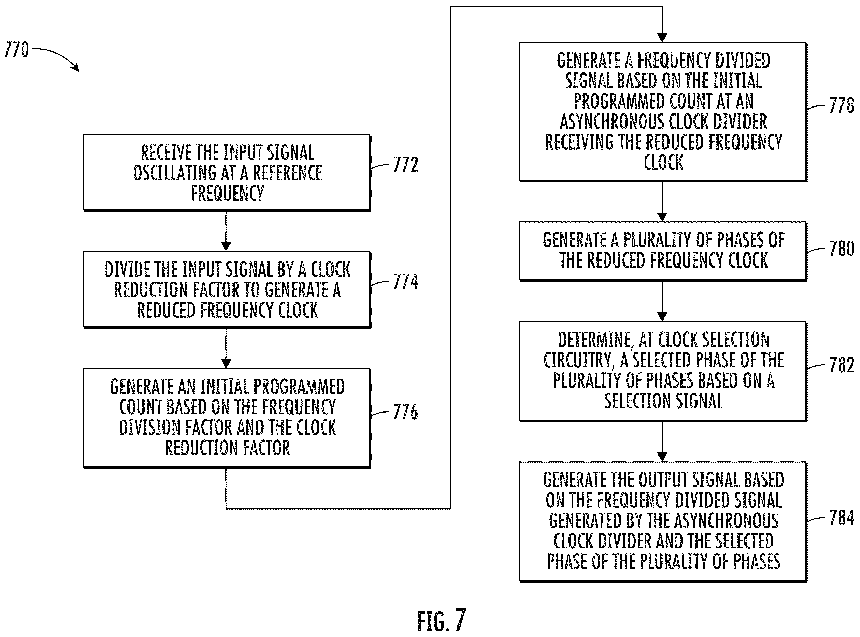

Referring now to FIG. 7, an flow diagram depicted a process 770 for generating an output signal (e.g., output signal 110) proportional to an input signal (e.g., input signal 106) by a frequency division factor (e.g., frequency division factor 102) in accordance with a high-speed frequency divider (e.g., high-speed frequency divider 100) designed in accordance with one or more example embodiments of the present disclosure is provided.

At block 772, the high-speed frequency divider receives the input signal oscillating at a reference frequency. In some embodiments, the reference signal at which the input signal oscillates may be so high (e.g., greater than 2 gigahertz) as to reduce a loading time window available for loading values, for example, loading initial programmed counts (e.g., initial programmed count 242) into an asynchronous clock divider (e.g., asynchronous clock divider 226). Such reduced loading times may lead to inconsistent, or inaccurate results at an asynchronous clock divider.

At block 774, the high-speed frequency divider divides the input signal by a clock reduction factor to generate a reduced frequency clock. A clock reduction factor is specified so as to reduce the reference frequency of the input signal to a reduced frequency associated with the reduced frequency clock. The reduced frequency clock may then be provided to the asynchronous clock divider. By reducing the frequency of the clock received at the asynchronous clock divider, the loading times available to load initial programmed values may be increased. Thus, improving the operation of the high-speed frequency divider at high frequencies. As a non-limiting example, in an instance in which the input signal oscillates at a reference frequency of 5 gigahertz, and the clock reduction factor is four, the reduced frequency of the reduced frequency clock is (5/4 = 1.25) is 1.25 gigahertz.

At block 776, the high-speed frequency divider generates an initial programmed count based on the frequency division factor and the clock reduction factor. With the asynchronous clock divider operating at a reduced frequency (e.g., reduced frequency clock) the initial programmed count (e.g., initial programmed count 242) is adjusted to output an output signal with the desired output frequency. The initial programmed count is loaded into the asynchronous clock divider to dictate each half cycle of the output signal.

As described herein, the initial programmed count may be determined by dividing the frequency division factor by two times the clock reduction factor, where the two is based on the output divide factor of the divide two frequency divider circuitry. By reducing the initial programmed count based on the output divide factor of two, the initial programmed count is updated to account for the frequency divider circuitry. By reducing the initial programmed count by the clock reduction factor, the initial programmed count is updated to account for the reduced frequency of the reduced frequency clock driving the asynchronous clock divider.

At block 778, the high-speed frequency divider generates a frequency divided signal based on the initial programmed count at an asynchronous clock divider receiving the reduced frequency clock. In some embodiments, the asynchronous clock divider may be preloaded with the initial programmed count, or another value based on the initial programmed count (e.g., initial programmed count minus two in an N+2 asynchronous clock divider). An internal count may then be updated according to the reduced frequency clock 228. The asynchronous clock divider may then generate an output once the internal count has expired. For example, in some embodiments, the internal count may decrement. Once the internal count reaches zero, an output (e.g., frequency divided signal 244) may be generated. The frequency divided signal may indicate the clock transitions of the output signal (e.g., output signal 110).

At block 780, the high-speed frequency divider generates a plurality of phases (e.g., plurality of phases 252) of the reduced frequency clock. In some embodiments, the high-speed frequency divider may include clock generation circuitry (e.g., clock generation circuitry 250) configured to generate a plurality of phases of the reduced frequency clock. For example, the reduced frequency clock may be transmitted through a number of delays, flip-flops, or other electrical component. The number of clock phases comprising the plurality of phases depends on the clock reduction factor (e.g., clock reduction factor 104) used to generate the reduced frequency clock (e.g., reduced frequency clock 228). For example, the number phases may be equivalent to the base-2 log of the clock reduction factor. Each clock phase of the plurality of clock phases is shifted from the previous phase by a clock cycle of the input signal having a reference frequency.

At block 782, the high-speed frequency divider determines, at clock selection circuitry, a selected phase of the plurality of phases based on a selection signal. As described herein, the selection signal determines the selected clock cycle, wherein the selected clock cycle is the shifted frequency divided signal (e.g., shifted frequency divided signals 335a - 335n) generated within the clock selection circuitry used to define the transition of the output signal. Selecting from the plurality of shifted frequency divided signals enables the high-speed frequency divider to generate accurate frequency divided signals in an instance in which the desired frequency division factor is not a multiple of the clock reduction factor. Thus, the selection signal may dictate the shifted frequency divided signal aligning with the desired frequency division factor.

An update to the selection signal may be determined based on the frequency division factor, the output divide factor of two, and the clock reduction factor. In one non-limiting example, the high-speed frequency divider may include selection signal circuitry (e.g., selection signal circuitry 338) configured to update the selection signal based on the least significant bits of the frequency division factor. For example, one or more least significant bits of the frequency division factor may be added to the selection signal to determine the next selected signal during the generation of the output signal. The number of least significant bits used to determine the selection signal may depend on the number of shifted frequency divided signals generated within the clock selection circuitry (e.g., clock selection circuitry 230), and thus, may also depend on the clock reduction factor used to generate the reduced frequency clock. For example, the number of least significant bits used to generate the selection signal may be equivalent to the base-2 log of the clock reduction factor.

The update of the clock selection signal is enabled based on the output signal and the number of shifted frequency divided signals generated within the clock selection circuitry, such that the selection signal is updated prior to the completion of the generation of a clock cycle of the output signal.

At block 784, the high-speed frequency divider generates the output signal based on the frequency divided signal generated by the asynchronous clock divider and the selected phase of the plurality of phases. The assertion of the selected phase of the plurality of phases may indicate a transition of the output signal. For example, an assertion of the clock selection output signal may cause a transition in the output signal. In some embodiments, frequency divider circuitry (e.g., frequency divider circuitry 232) is further configured to receive the clock selection output signal and generate an output signal with reduced frequency based on the clock selection output signal. For example, the frequency divider circuitry may reduce the frequency of the clock selection output signal by a factor of two based on the output divide factor of the divide two frequency divider circuitry. In some embodiments, the output divide factor may be another power of two, for example 4, 8, 16, etc.

Referring now to FIG. 8, an example phase-locked loop 880 is provided. As depicted in FIG. 8, the example phase-locked loop 880 includes a phase frequency detector 884 configured to receive a reference signal 882 and a feedback signal 891. The phase frequency detector 884 is configured to determine a frequency and/or phase difference between the reference signal 882 and the feedback signal 891 and generate an up output signal 885a and a down output signal 885b based on the frequency and/or phase difference.

As further depicted in FIG. 8, the phase frequency detector 884 is electrically connected to a charge pump 886. The charge pump 886 comprises any circuitry including hardware and/or software configured to convert the up output signal 885a and the down output signal 885b into a control voltage (e.g., charge pump output 887) compatible with the voltage-controlled oscillator 890. The charge pump 886 may boost the voltage, convert the voltage, or perform any other operation necessary to convert the up output signal 885a and the down output signal 885b into a control voltage. For example, in some embodiments, the up output signal 885a may control a transistor device electrically connected to a voltage source and configured to increase the voltage of the charge pump output 887 when the up output signal 885a is asserted. In some embodiments, the down output signal 885b may control a transistor device electrically connected to an electrical ground and configured to decrease the voltage of the charge pump output 887 when the down output signal 885b is asserted.

As further depicted in FIG. 8, the charge pump 886 is electrically connected to a loop filter 888. The loop filter 888 comprises any circuitry including hardware and/or software configured to receive and filter the charge pump output 887 to generate a filtered output voltage (e.g., oscillator voltage 889). The loop filter 888 may remove high frequency noise or perform other similar signal filtering operations to generate the oscillator voltage 889.

As further depicted in FIG. 8, the loop filter 888 is electrically connected to a voltage-controlled oscillator 890. A voltage-controlled oscillator 890 comprises any circuitry including hardware and/or software configured to generate an output signal 892 with a frequency that is adjusted and/or controlled based on the voltage of the oscillator voltage 889. In some embodiments, the frequency of the output signal 892 may be directly proportional to the oscillator voltage 889. Thus, in some embodiments, in an instance in which the up output signal 885a is asserted, the voltage of the charge pump output 887 and the oscillator voltage 889 increases, increasing the frequency of the output signal 892. Conversely, in an instance in which the down output signal 885b is asserted, the voltage of the charge pump output 887 and the oscillator voltage 889 decreases, decreasing the frequency of the output signal 892.

As further depicted in FIG. 8, the output signal 892 of the voltage-controlled oscillator 890 is fed back to a frequency divider 100 in accordance with one or more embodiments of the present disclosure. The frequency divider 100 is configured to receive the output signal 892 from the voltage-controlled oscillator 890 and generate a feedback signal 891 having a reduced frequency relative to the frequency of the output signal 892.

As depicted in FIG. 8, when positioned in the feedback path of the phase-locked loop 880, the frequency divider 100 receives the output signal 892 as input signal 106 and generates the feedback signal 891 (e.g., output signal 110). Positioning the frequency divider 100 in the feedback path of the phase-locked loop 880 enables frequency synthesis, scaling, and stability in the output signal 892 of the phase-locked loop 880 based on the reference signal 882. For example, to generate an output signal 892 (e.g., input signal 106) based on the reference signal 882, but scaled to a higher frequency, the frequency divider 100 may generate the feedback signal 891 (e.g., output signal 110) at a reduced frequency of the output signal 892 (e.g., input signal 106). The reduced frequency feedback signal 891 (e.g., output signal 110) is provided to the phase frequency detector 884 and compared with the reference signal 882. The comparison enables the phase-locked loop 880 to lock the output signal 892 (e.g., input signal 106) to an integer multiple of the reference signal 882. By adjusting the frequency division factor (e.g., frequency division factor 102) of the frequency divider 100, the phase-locked loop 880 can effectively multiply the reference signal 882 to generate a stable output signal 892 at higher frequencies. For example, if the desired frequency of the output signal 892 is 10 megahertz and the reference signal 882 oscillates at 1 megahertz, the frequency division factor may be set to 10, enabling the phase-locked loop 880 to lock the output signal 892 (e.g., input signal 106) at 10 megahertz while generating a feedback signal 891 (e.g., output signal 110) at 1 megahertz.

In some embodiments, the divide ratio may be dynamically updated to generate an output signal 892 of different frequencies. For example, in an instance in which a chirp radar signal is generated, the frequency division factor may be continuously updated over a set time to generate a frequency-modulated output signal 892 that sweeps across a range of frequencies over the set time.

While this detailed description has set forth some embodiments of the present invention, the appended claims cover other embodiments of the present invention which differ from the described embodiments according to various modifications and improvements. For example, that utilizes a phase locked loop to synchronize with a reference signal. For example, frequency synthesis applications, such as radio transmitters, receivers, and signal generators; clock generation applications, such as clock generation blocks in CPUs, GPUs, and networking equipment; communication system applications, such as synchronizing data signals in wired and wireless communications; motor control and robotics applications; telecommunications applications; and so on.

Use of broader terms such as "comprises," "includes," and "having" should be understood to provide support for narrower terms such as "consisting of," "consisting essentially of," and "comprised substantially of" Use of the terms "optionally," "may," "might," "possibly," and the like with respect to any element of an embodiment means that the element is not required, or alternatively, the element is required, both alternatives being within the scope of the embodiment(s). Also, references to examples are merely provided for illustrative purposes, and are not intended to be exclusive.

## Claims

1. A high-speed frequency divider (100), configured to generate an output signal (110) proportional to an input signal (106) by a frequency division factor (102), comprising:

   the input signal (106) oscillating at a reference frequency;
   a reduced frequency clock (228) oscillating at a reduced frequency, wherein the reduced frequency clock (228) is generated by dividing the input signal (106) by a clock reduction factor (104);
   an asynchronous clock divider (226) configured to update an initial programmed count in synchronization with the reduced frequency clock (228) and generate a frequency divided signal (244) based on the initial programmed count, wherein the initial programmed count is based on the frequency division factor (102) and the clock reduction factor (104); and
   clock selection circuitry (230) configured to generate a plurality of phases (252) of the reduced frequency clock (228) and select a selected phase of the plurality of phases (252) based on a received selection signal (248) ;
wherein the output signal (110) is based on the frequency divided signal (244) generated by the asynchronous clock divider (226) and the selected phase of the plurality of phases (252).

2. The high-speed frequency divider (100) of claim 1, wherein the clock selection circuitry (230) is configured to generate a clock selection output signal (246), and the output signal is generated by dividing the clock selection output signal (246) by an output divide factor.

3. The high-speed frequency divider (100) of claim 2, wherein the initial programmed count at the asynchronous clock divider (226) is determined by performing an integer division operation on the frequency division factor (102) by a product of the output divide factor and the clock reduction factor (104).

4. The high-speed frequency divider (100) of claim 3, wherein the integer division operation generates an integer division remainder based on a remainder of the integer division operation on the frequency division factor by the product of the output divide factor and the clock reduction factor (104).

5. The high-speed frequency divider (100) of claim 4, wherein the integer division remainder is accumulated as an accumulated integer division remainder between successive divide operations, and wherein the initial programmed count is incremented in an instance in which the accumulated integer division remainder is equal to one.

6. The high-speed frequency divider (100) of claim 2, wherein the clock selection circuitry (230) includes a clock selection mux (336) configured to select a selected clock signal to output as the clock selection output signal based on the selection signal.

7. The high-speed frequency divider (100) of claim 6, wherein a next selected signal indicating a next selected phase of the plurality of phases (252) at the clock selection circuitry (230) is generated based on one or more least significant bits of the frequency division factor, the selection signal (248), the output signal (110), and each of the plurality of phases (252) of the reduced frequency clock (228).

8. The high-speed frequency divider (100) of claim 7, wherein the next selected signal is incremented by the one or more least significant bits of the frequency division factor in an instance in which the output signal (110) and each phase of the plurality of phases (252) of the clock selection circuitry (230) is asserted.

9. The high-speed frequency divider (100) of claim 2, wherein the output divide factor is two.

10. The high-speed frequency divider (100) of claim 1, wherein a number of phases comprising the plurality of phases (252) received at the clock selection circuitry is based on the clock reduction factor (104).

11. A method for generating an output signal (110) proportional to an input signal (106) by a frequency division factor, the method comprising:

receiving the input signal (106) oscillating at a reference frequency;
dividing the input signal by a clock reduction factor (104) to generate a reduced frequency clock;
generating an initial programmed count based on the frequency division factor and the clock reduction factor (104) ;
generating a frequency divided signal based on the initial programmed count at an asynchronous clock divider (226) receiving the reduced frequency clock;
generating a plurality of phases (252) of the reduced frequency clock;
determining, at clock selection circuitry, a selected phase of the plurality of phases based on a selection signal; and
generating the output signal (110) based on the frequency divided signal generated by the asynchronous clock divider (226) and the selected phase of the plurality of phases (252).

12. The method of claim 11, further comprising:

generating, at the clock selection circuitry (230), a clock selection output signal (246); and
dividing the clock selection output signal (246) by an output divide factor to generate the output signal (110).

13. The method of claim 12, further comprising:

executing an integer division operation on the frequency division factor and a product of the output divide factor and the clock reduction factor; and
determining the initial programmed count based on the integer division operation.

14. The method of claim 13, further comprising:
determining an integer division remainder based on a remainder of the integer division operation.

15. A phase-locked loop configured to generate a phase-locked signal based on a reference signal, comprising:

a voltage-controlled oscillator configured to generate the phase-locked signal based on an oscillator voltage signal;

a low-pass filter electrically connected to the voltage-controlled oscillator and configured to generate the oscillator voltage signal based on a charge pump output signal;

a charge pump circuit electrically connected to the low-pass filter and configured to generate the charge pump output signal based on an up output signal and a down output signal from a phase frequency detector;

a phase frequency detector circuit configured to generate the up output signal and the down output signal, based on a phase difference between the reference signal and a feedback signal; and

a high-speed frequency divider according to any one of claims 1 to 10, wherein the output signal is the feedback signal and the input signal is the phase-locked signal.

EP 4 779 875 A1

FREQUENCY DIVISION FACTOR
102 ———————————————→

CLOCK REDUCTION FACTOR
104 ———————————————→

INPUT SIGNAL
106 ———————————————→

HIGH SPEED FREQUENCY DIVIDER
100

———→ OUTPUT SIGNAL
110

FIG. 1

FIG. 2

FIG. 3

FIG. 4

FIG. 5

FIG. 6

FIG. 7

EP 4 779 875 A1

EP 4 779 875 A1

880

882 | PFD 884 | 885a → CP 886 | 887 → LPF 888 | 889 → VCO 890 → 892

885b

891

HIGH SPEED FREQUENCY DIVIDER 100

110

106

FIG. 8

Europäisches
Patentamt
European
Patent Office
Office européen
des brevets

# EUROPEAN SEARCH REPORT

**Application Number**

EP 26 15 1469

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 311 490 B1 (ERICSSON TELEFON AB L M [SE]) 24 April 2019 (2019-04-24) | 1,2, 6-12,15 | INV. H03K23/66 |
| A | * paragraph [0020]; figure 2 * <br> * paragraphs [0026] - [0030]; figure 3 * <br> * paragraphs [0031], [0032]; figure 4 * <br> ----- | 3-5,13, 14 | |
| A | US 2006/220697 A1 (FLYNN CINDA L [US]) 5 October 2006 (2006-10-05) <br> * paragraph [0021]; figures 1,2 * <br> ----- | 1-15 | |
| A | US 2009/302900 A1 (MARUTANI MASAZUMI [JP]) 10 December 2009 (2009-12-10) <br> * paragraphs [0078] - [0089]; figure 1 * <br> ----- | 1-15 | |

**TECHNICAL FIELDS SEARCHED (IPC)**

H03K

The present search report has been drawn up for all claims

| Place of search | Date of completion of the search | Examiner |
|---|---|---|
| Munich | 21 May 2026 | Martínez Martínez, J |

EPO FORM 1503 03.82 (P04C01)

**EP 4 779 875 A1**

## ANNEX TO THE EUROPEAN SEARCH REPORT
## ON EUROPEAN PATENT APPLICATION NO.

EP 26 15 1469

This annex lists the patent family members relating to the patent documents cited in the above-mentioned European search report.
The members are as contained in the European Patent Office EDP file on
The European Patent Office is in no way liable for these particulars which are merely given for the purpose of information.

21-05-2026

| Patent document cited in search report | | Publication date | Patent family member(s) | | Publication date |
|---|---|---|---|---|---|
| EP 3311490 | B1 | 24-04-2019 | AR | 105007 A1 | 30-08-2017 |
| | | | AU | 2015399336 A1 | 18-01-2018 |
| | | | CN | 107750432 A | 02-03-2018 |
| | | | EP | 3311490 A1 | 25-04-2018 |
| | | | JP | 6484354 B2 | 13-03-2019 |
| | | | JP | 2018522472 A | 09-08-2018 |
| | | | KR | 20180006964 A | 19-01-2018 |
| | | | MX | 371491 B | 31-01-2020 |
| | | | MY | 182290 A | 18-01-2021 |
| | | | PH | 12017502159 A1 | 28-05-2018 |
| | | | RU | 2668737 C1 | 02-10-2018 |
| | | | US | 2018159546 A1 | 07-06-2018 |
| | | | US | 2018367153 A1 | 20-12-2018 |
| | | | WO | 2016202367 A1 | 22-12-2016 |
| | | | ZA | 201708326 B | 26-06-2019 |
| US 2006220697 | A1 | 05-10-2006 | CN | 101167242 A | 23-04-2008 |
| | | | KR | 20070114304 A | 30-11-2007 |
| | | | TW | I380578 B | 21-12-2012 |
| | | | US | 2006220697 A1 | 05-10-2006 |
| | | | WO | 2006107393 A1 | 12-10-2006 |
| US 2009302900 | A1 | 10-12-2009 | AT | E521136 T1 | 15-09-2011 |
| | | | EP | 2154786 A1 | 17-02-2010 |
| | | | JP | 5169601 B2 | 27-03-2013 |
| | | | JP | 2010041466 A | 18-02-2010 |
| | | | US | 2009302900 A1 | 10-12-2009 |

EPO FORM P0459

For more details about this annex : see Official Journal of the European Patent Office, No. 12/82